# EUROPEAN PATENT APPLICATION

(11) **EP 4 654 777 A1**
(43) Date of publication of application: **26.11.2025**
(21) Application number: 24212262.0
(22) Date of filing: 12.11.2024
(51) Int. Cl.: H10D 1/66, H10D 1/68, H10D 30/60, H10D 30/67, H10D 84/80, H10D 86/01, H10D 86/00

(54) **HIGH-DENSITY STACKED CAPACITOR AND METHOD**

(30) Priority: 20.05.2024 US 202418668706
(71) Applicant: GlobalFoundries U.S. Inc., Malta, NY 12020 (US)
(72) Inventor: Balasubramaniyan, Arul, Richardson, 75094 (US); Zhang, Chi, Richardson, 75094 (US); Bellaouar, Abellatif, Richardson, 75082 (US); Syed, Shafiullah, Richardson, 75094 (US); Meza Campos, Miguel Angel, Richardson, 75094 (US)
(74) Representative: Grünecker Patent- und Rechtsanwälte PartG mbB

(57) **Abstract**

Disclosed are a high-density stacked capacitor (1, 100) and an associated formation method. The high-density stacked capacitor includes: first and second terminals (191, 192); and a stack of parallel-connected capacitors between the terminals. The stack includes a first capacitor (e.g., a planar transistor-type capacitor, 110) including: a channel region (113) positioned laterally between source/drain regions (111, 112), which are connected to the first terminal; and front and back gates (115, 116), which are above and below the channel region and connected to the second terminal. The stack also includes at least one additional capacitor (e.g., a metal-oxide-metal capacitor (MOMCAP), 1201) aligned above the front gate of the first capacitor in a back end of the line (BEOL) metal level. Optionally, the capacitor includes multiple additional capacitors (1202-120n) aligned above the front gate and stacked vertically one above the other in different BEOL metal levels. Each additional capacitor includes interdigitated first and second capacitor plates (1211, 1221) connected to the first and second terminals, respectively.

## Description

### BACKGROUND

The present disclosure relates to capacitors and, more particularly, to embodiments of a high-density stacked capacitor and method of forming the high-density stacked capacitor.

High-density capacitors serve a variety of different functions on integrated circuit (IC) chips. For example, high-density capacitors are used as bypass capacitors in filters (e.g., analog baseband filters or phase locked loop (PLL) filters). They are also used as compensation capacitors in operational amplifiers (op-amps) or used for setting the bandwidth in transimpedance amplifiers (TIAs). As ICs are scaled in size, it would be advantageous to have capacitor structures that consume less chip area while exhibiting larger capacitance values.

### SUMMARY

Disclosed herein are embodiments of a semiconductor structure including a high-density stacked capacitor with first and second terminals.

In some embodiments of the semiconductor structure, the high-density stacked capacitor can include a first capacitor. The first capacitor can include a transistor. The transistor can include: a channel region in a semiconductor layer positioned laterally between source/drain regions; a back gate adjacent to a bottom surface of the semiconductor layer at the channel region; and a front gate adjacent to a top surface of the semiconductor layer at the channel region. The source/drain regions can be connected to the first terminal and the front and back gates can be connected to the second terminal. The high-density stacked capacitor can further include a dielectric layer on the transistor and an additional capacitor above the dielectric layer. The additional capacitor can extend at least partially over the front gate and can include interdigitated capacitor plates connected to the first and second terminals, respectively.

In other embodiments of the semiconductor structure, the high-density stacked capacitor can include a first capacitor. The first capacitor can include a transistor. The transistor can include: a channel region in a semiconductor layer positioned laterally between source/drain regions; a back gate adjacent to a bottom surface of the semiconductor layer at the channel region; and a front gate adjacent to a top surface of the semiconductor layer at the channel region. The source/drain regions can be connected to the first terminal and the front and back gates can be connected to the second terminal. The high-density stacked capacitor can further include a dielectric layer on the transistor and a stack of additional capacitors above the dielectric layer. The additional capacitors in the stack can be in different metal levels and can extend at least partially over the front gate. Each additional capacitor can include interdigitated capacitor plates connected to the first and second terminals, respectively.

Also disclosed herein are embodiments of a method of forming the above-described semiconductor structures. The method can include forming a first capacitor. This first capacitor can be a transistor that includes: a channel region in a semiconductor layer positioned laterally between source/drain regions; a back gate adjacent to a bottom surface of the semiconductor layer at the channel region; and a front gate adjacent to a top surface of the semiconductor layer at the channel region. The method can further include forming a dielectric layer on the transistor. The method can further include forming at least one additional capacitor, which is above the dielectric layer, extends at least partially over the front gate, and includes interdigitated capacitor plates. The method can further include performing middle of the line (MOL) and back end of the line (BEOL) processing such that the source/drain regions of the transistors connected to a first terminal of a high-density stack capacitor made up of the first capacitor and additional capacitor(s), such that the front and back gates of the transistor are connected to a second terminal of the high-density stack capacitor, and such that the interdigitated capacitor plates of each additional capacitor are connected to the first and second terminals, respectively.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIGs. 1A, 1B, and 1C are a schematic diagram, a layout diagram, and a cross-section diagram, respectively, illustrating disclosed embodiments of a semiconductor structure;
FIG. 2 is a flow diagram illustrating disclosed embodiments of a method of forming the semiconductor structure;
FIGs. 3A-3D are cross-section diagrams illustrating partially completed semiconductor structures formed according to the disclosed method embodiments;
FIGs. 3E-1 and 3E-2 are a cross-section diagram and a top view diagram, respectively, illustrating a partially completed semiconductor structure formed according to the disclosed method embodiments;
FIGs. 3F-1 and 3F-2 are a cross-section diagram and a top view diagram, respectively, illustrating a partially completed semiconductor structure formed according to the disclosed method embodiments; and
FIGs. 3G-1 and 3G-2 are a cross-section diagram and a top view diagram, respectively, illustrating a semiconductor structure formed according to the disclosed method embodiments.

### DETAILED DESCRIPTION

As mentioned above, high-density capacitors serve a variety of different functions on integrated circuit (IC) chips. For example, high-density capacitors are used as bypass capacitors in filters (e.g., analog baseband filters or phase locked loop (PLL) filters). They are also used as compensation capacitors in operational amplifiers (op-amps) or used for setting the bandwidth in transimpedance amplifiers (TIAs). As ICs are scaled in size, it would be advantageous to have capacitor structures that consume less chip area while exhibiting larger capacitance values.

In view of the foregoing, disclosed herein are embodiments of a semiconductor structure including a high-density stacked capacitor including: a first terminal; a second terminal; and a stack of capacitors connected in parallel between the first terminal and the second terminal for high capacitance density. The stack can include a first capacitor and, particularly, a planar transistor-type capacitor (e.g., metal oxide semiconductor capacitor (MOSCAP)) with front and back gates. For example, the first capacitor could be a fully or partially depleted semiconductor-on-insulator field effect transistor with a channel region positioned laterally between electrically coupled source/drain regions and with front and back gates above and below the channel region, respectively, as discussed in greater detail below). The source/drain regions can be connected to the first terminal and the front and back gates can be connected to the second terminal. The stack can further include at least one additional capacitor (e.g., a metal-oxide-metal capacitor (MOMCAP)) aligned above the front gate of the first capacitor in a back end of the line (BEOL) metal level. Optionally, the stack can include multiple additional capacitors (e.g., multiple MOMCAPs) aligned above the front gate and stacked vertically one above the other in different BEOL metal levels. Each additional capacitor can include interdigitated first and second capacitor plates. The first plate of the additional capacitor(s) can be connected to the first terminal and the second plate can be electrically coupled to the second terminal. Thus, all capacitors in the stack are connected in parallel. Also disclosed herein are embodiments of a method of forming the above-described high-density stacked capacitor.

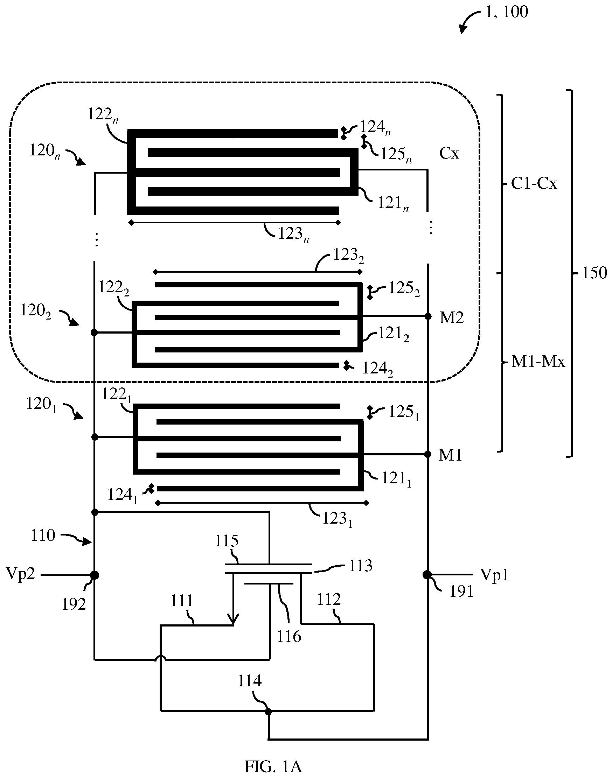

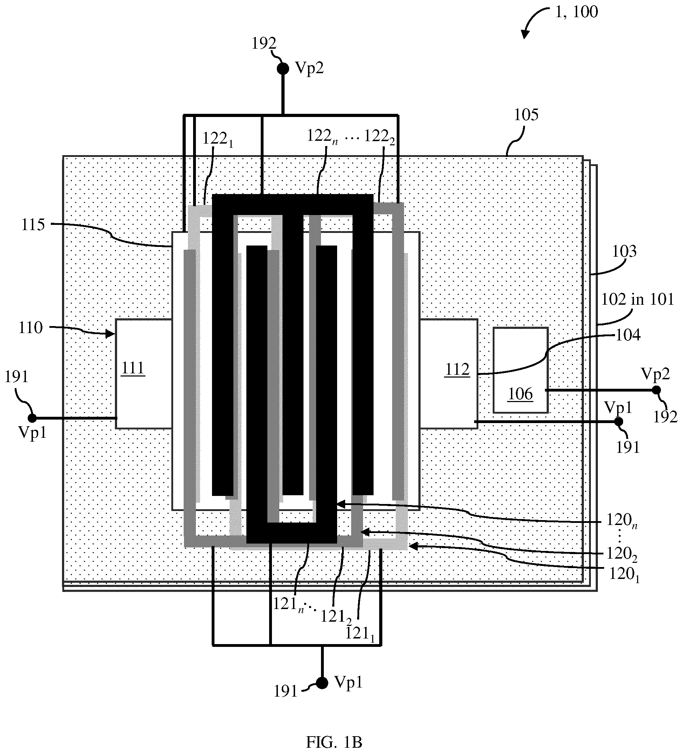

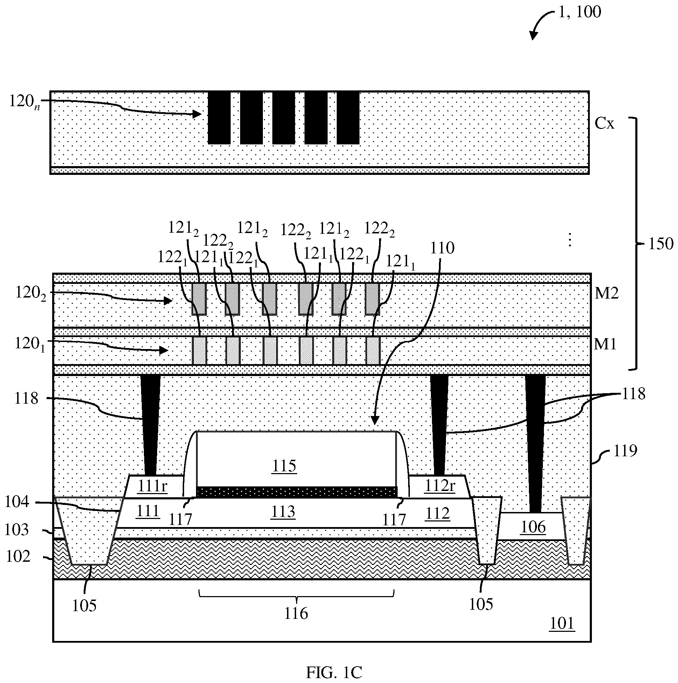

FIGs. 1A, 1B, and 1C are a schematic diagram, a layout diagram, and a cross-section diagram, respectively, illustrating disclosed embodiments of a semiconductor structure 1.

Semiconductor structure 1 can include a semiconductor substrate 101. Semiconductor substrate 101 can be, for example, a monocrystalline silicon substrate or a substrate of any other suitable monocrystalline semiconductor material (e.g., silicon germanium, etc.). Semiconductor structure 1 can further include an insulator layer 103 on semiconductor substrate 101. Insulator layer 103 can be, for example, a silicon dioxide layer or a layer of any other suitable insulator material. Semiconductor structure 1 can further include a semiconductor layer 104 on insulator layer 103. Semiconductor layer 104 can be, for example, a monocrystalline silicon layer or a layer of any other suitable monocrystalline semiconductor material (e.g., silicon germanium, etc.). Semiconductor structure 1 can further include a high-density stacked capacitor 100.

High-density stacked capacitor 100 can include: a first terminal 191; a second terminal 192; and a stack of at least two capacitors connected in parallel between first terminal 191 and second terminal 192. For purposes of this disclosure, a high-density capacitor refers to a capacitor designed to create a relatively large amount of capacitance within a relatively small area of a chip. A stacked capacitor refers to multiple capacitors connected in parallel.

Specifically, the stack of capacitors in high-density stacked capacitor 100 can include a first capacitor 110. First capacitor 110 can be a planar transistor-type capacitor (e.g., a MOSCAP) with front and back gates. For example, first capacitor 110 can be a semiconductor-on-insulator field effect transistor with electrically coupled source/drain regions 111-112. In some embodiments, first capacitor 110 can be a fully depleted silicon-on-insulator (FDSOI) field effect transistor (FET) (or a partially depleted silicon-on-insulator (PDSOI) FET) with electrically coupled source/drain regions 111-112. In some embodiments, first capacitor 110 can be an FDSOI or PDSOI N-type FET (NFET) with electrically coupled source/drain regions 111-112.

More specifically, first capacitor 110 can include an active device region within semiconductor layer 104. Boundaries of the active device region can be defined by an isolation region 105. Isolation region 105 can be, for example, a shallow trench isolation (STI) structure. This STI structure can include a trench, which extends vertically through semiconductor layer 104 to and, optionally, through insulator layer 103 and which further laterally surrounds a portion of semiconductor layer 104. The trench can be filled with one or more layers of isolation material (e.g., silicon dioxide, silicon oxynitride, silicon nitride, or any other suitable type of isolation material).

First capacitor 110 can further include a channel region 113 within semiconductor layer 104 in the active device region and positioned laterally between source/drain regions 111-112 (which are electrically connected, as discussed below). Source/drain regions 111-112 can include portions of semiconductor layer 104. As illustrated in the schematic diagram of FIG. 1A, the FET of first capacitor 110 can be, for example, an N-type field effect transistor (NFET). In this case, source/drain regions 111-112 can have N-type conductivity at a relatively high conductivity level (e.g., can be N+ source/drain regions). In this case, channel region 113 can be an intrinsic channel region (i.e., an undoped channel region) or channel region 113 can have P-type conductivity at a relatively low conductivity level (e.g., channel region 113 can be a P-channel region). However, FIG. 1A is not intended to be limiting. Alternatively, FET of first capacitor 110 can be, for example, a P-type field effect transistor (PFET). In this case, source/drain regions 111-112 can have P-type conductivity at a relatively high conductivity level (e.g., can be P+ source/drain regions). In this case, channel region 113 can be an intrinsic channel region (i.e., an undoped channel region) or channel region 113 can have N-type conductivity at a relatively low conductivity level (e.g., channel region 113 can be an N- channel region).

First capacitor 110 can further include a front gate 115 adjacent to the top surface of semiconductor layer 104 at channel region 113 (i.e., above the channel region 113). Front gate 115 can include a gate dielectric layer immediately adjacent to the top surface of semiconductor layer 104 at channel region 113. The gate dielectric layer can include one or more layers of gate dielectric material (e.g., a silicon dioxide gate dielectric material, a high-K gate dielectric material, etc.). Front gate 115 can further include a gate conductor layer on the gate dielectric layer. The gate conductor layer can include one or more layers of gate conductor material (e.g., a doped-polysilicon gate conductor material, a metal or metal alloy gate conductor material, etc.). The front gate 115 can have any suitable front gate structure. For example, front gate 115 could be a gate-first silicon dioxide-polysilicon gate structure, a gate-first high-K dielectric-metal gate structure, a replacement metal gate structure, etc. Such front gate structures are known in the art and, thus, the details thereof have been omitted from this specification in order to allow the reader to focus on the salient aspects of the disclosed embodiments. In any case, the FET can further include gate sidewall spacers 117 positioned laterally adjacent to sidewalls of the front gate 115.

Optionally, first capacitor 110 can further include raised source/drain regions 111r-112r on the top surface of semiconductor layer 104 immediately adjacent to source/drain regions 111-112, respectively. Raised source/drain regions 111r-112r can be in situ-doped epitaxial semiconductor layers having the same type conductivity as source/drain regions 111-112. Raised source/drain regions 111r-112r can be physically separated and electrically isolated from front gate 115 by the gate sidewall spacers 117.

First capacitor 110 can further include a back gate 116 adjacent to the bottom surface of semiconductor layer 104 at channel region 113 (i.e., below the channel region). Specifically, semiconductor structure 1 can further include a well region 102 within semiconductor substrate 101 immediately adjacent to insulator layer 103 and aligned below the active device region.

For purposes of this disclosure, a well region refers to a region of semiconductor material doped (e.g., via a dopant implantation process or any other suitable doping process) so as to have a particular type of conductivity (e.g., N-type conductivity or P-type conductivity). In fully depleted semiconductor on insulator technology processing platforms a well region in the semiconductor substrate aligned below a transistor can be employed to tune the threshold voltage (VT) of the transistors. A well region doped so as to have N-type conductivity is referred to herein as an Nwell and a well region doped so as to have P-type conductivity is referred to herein as a Pwell. For super low threshold voltage (SLVT) or low threshold voltage (LVT) FETs, NFETs can be formed above Nwells and PFETs can be formed above Pwells. For regular threshold voltage (RVT) or high threshold voltage (HVT) FETs, NFETs can be formed above Pwells and PFETs can be formed above Nwells. Those skilled in the art will recognize that whether the FETs are SLVT or LVT FETs or whether they are RVT or HVT FETs will depend upon the design (e.g., device size, etc.) and process specifications (e.g., dopant concentrations, etc.). In the disclosed embodiments, the FET of first capacitor 110 can be a SLVT or LVT FET. Thus, for example, if the FET of the first capacitor 110 is a SLVT or LVT NFET (as illustrated in FIG. 1A), well region 102 can be an Nwell.

Total capacitance provided by first capacitor 110 includes at least a front gate capacitance and a back gate capacitance. For purposes of this disclosure, front gate capacitance refers to capacitance created by a capacitor formed with the gate conductor material of front gate 115 and channel region 113 as capacitor plates and the gate dielectric material of front gate 115 as the capacitor dielectric. Furthermore, back gate capacitance refers to capacitance created by a capacitor and, particularly, an in-substrate PN junction capacitor formed at the interface between semiconductor substrate material with one type conductivity (e.g., P- semiconductor material) and well region 102 of back gate 116, which is within the semiconductor substrate and which has the opposite type conductivity (e.g., an Nwell).

First capacitor 110 can further include a well tap 106. Those skilled in the art will recognize that fully depleted semiconductor-on-insulator (e.g., FDSOI) semiconductor structures typically include combinations of semiconductor-on-insulator regions and bulk regions. Bulk regions will be devoid of the semiconductor layer and insulator layer. Well tap 106 can, for example, be located in a bulk region. Well tap 106 can be an epitaxial semiconductor layer on the top surface of semiconductor substrate 101 immediately adjacent to well region 102. Alternatively, well tap 106 can be an additional doped region within well region 102. In either case, well tap 106 can have the same type conductivity as well region 102 at higher conductivity level. For example, for an Nwell, well tap can be a N+ well tap. Well tap 106 can be electrically isolated from the active device region (e.g., by an STI structure).

In high-density stacked capacitor 100, first capacitor 110 can be covered by a middle of the line (MOL) dielectric layer 119. MOL dielectric layer 119 can include one or more layers of interlayer dielectric (ILD) material. The layer(s) of ILD material can include, for example, an optional conformal etch stop layer (e.g., a conformal silicon nitride layer) and a blanket dielectric layer on the etch stop layer. The blanket dielectric layer can be, for example, a layer of silicon dioxide or a layer of any other suitable ILD material such as borophosphosilicate glass (BPSG) or phosphosilicate glass (PSG)). In any case, the top surface of MOL dielectric layer 119 can be essentially planar. MOL contacts 118 can extend vertically through MOL dielectric layer 119 to the various terminals of the transistor. As illustrated in FIG. 1C, MOL contacts 118 can include, but are not limited to, contacts to source/drain regions 111-112 (or, if applicable, contacts to raised source/drain regions 111r-112r) and a contact to well tap 106 (and thereby to back gate 116). MOL contacts 118 can also include a contact to front gate 115, which is not shown as such a contact would typically be offset from the active device region.

High-density stacked capacitor 100 can further include at least one additional capacitor 120₁ above MOL dielectric layer 119. Additional capacitor 120₁ can be within a first metal level (e.g., M1) of the BEOL metal levels 150 above the MOL dielectric layer 119. Additional capacitor 120₁ can be a metal oxide metal capacitor (MOMCAP) (e.g., an alternate polarity (AP) MOMCAP).

Specifically, additional capacitor 120₁ can include interdigitated first and second capacitor plates 121₁ and 122₁. First capacitor plate 121₁ can include a first connector adjacent and parallel to one side of front gate 115. Second capacitor plate 122₁ can include a second connector adjacent and parallel to the opposite side of front gate 115 (i.e., parallel to the first connector). First capacitor plate 121₁ can further include first fingers that extend at least partially across front gate 115 in one direction (i.e., toward the second connector). Second capacitor plate 122₁ can include second fingers that extend at least partially across front gate 115 in the opposite direction (i.e., toward the first connect) and on either side of the first fingers such that the first and second fingers of the first and second capacitor plates 121₁ and 122₁ are interdigitated. First and second capacitor plates 121₁ and 122₁ of additional capacitor 120₁ can be physically separated by ILD material of M1, which functions as the capacitor dielectric.

Optionally, high-density stacked capacitor 100 can include more than one additional capacitor. That is, high-density stacked capacitor can include additional capacitor 120₁ as described above in M1, plus one or more additional capacitors 120₂-120*ₙ* stacked vertically one above the other in different BEOL metal levels (e.g., any of M2-Cx).

Specifically, like additional capacitor 120₁, additional capacitor(s) 120₂-120*ₙ* can be MOMCAPs (e.g., AP-MOMCAPs), each including interdigitated first and second capacitor plates 121₂-121*ₙ* and 122₂-122*ₙ*. Each first capacitor plate 121₂-121*ₙ* can include a first connector stacked above a first connector of a first capacitor plate below. Each second capacitor plate 122₂-122*ₙ* can include a second connector stacked above a second connector of a second capacitor plate below. Each first capacitor plate 121₂-121*ₙ* can further include first fingers that extend at least partially across front gate 115 in one direction (i.e., toward the second connector). Each second capacitor plate 122₂-122*ₙ* can include second fingers that extend at least partially across front gate 115 in the opposite direction (i.e., toward the first connector) and on either side of the first fingers such that the first and second fingers of the first and second capacitor plates are interdigitated. First and second capacitor plates of each additional capacitor can be physically separated by ILD material the metal level within which they are formed and this ILD material functions as the capacitor dielectric. Adjacent additional capacitors within the stack are similarly physically separated by metal level ILD material.

As indicated in FIG. 1A, some parameters of the interdigitated first and second capacitor plates 121₁ -121*ₙ* and 122₁-122*ₙ* in each additional capacitor 120₁-120*ₙ* described above include, but are not limited to, capacitor plate material, capacitor dielectric material, numbers of first fingers, numbers of second fingers, finger length 123₁-123*ₙ*, finger spacing 125₁-125*ₙ*, finger and connector width 124₁-124*ₙ*, finger thickness, etc. In some embodiments, two or more of the additional capacitors 120₁-120*ₙ* can be differently configured. That is, they can have different physical parameters, such as different capacitor metal materials, different capacitor dielectric materials, different numbers of first and/or second fingers, different finger lengths, different finger spacings, different finger widths, and/or different finger thicknesses. It should be understood that at least some of these parameters can be limited by metal level-specific design specifications. For example, design specifications may indicate different ILD materials for different metal levels (e.g., low-K ILD material at M1, tetraethyl orthosilicate (TEOS) or fluorinated tetraethyl orthosilicate (FTEOS) ILD material in one or more of the highest metal levels, and ultralow-K ILD material in the metal levels therebetween). Design specifications may indicate different metals for different metal levels (e.g., aluminum in one or more of the highest metal levels and copper in the lower metal levels). Design specifications may indicate different critical dimensions (metal widths, heights, pitches, etc.) for the different metal levels. Thus, for example, in some embodiments, an additional capacitor 120*ₙ* in the highest metal level (e.g., Cx) may include a different capacitor metal material and/or a different capacitor dielectric material than any additional capacitor(s) below. Furthermore, it may have wider and/or thicker fingers with different finger-to-finger spacing than any additional capacitor(s) below.

Optionally, within the stack, first fingers of first capacitor plates of adjacent additional capacitors can be offset vertically and second fingers of second capacitor plates of adjacent additional capacitors are offset vertically so first fingers overlay second fingers and vice versa. Specifically, as illustrated in FIG. 1B, the first fingers of first capacitor plate 121₂ of additional capacitor 120₂ are oriented in the same first direction as the first fingers of first capacitor plate 121₁ of additional capacitor 120₁ below. However, they are offset vertically (i.e., the first fingers of first capacitor plate 121₂ do not overlay the first fingers of first capacitor plate 121₁). Additionally, the second fingers of second capacitor plate 122₂ of additional capacitor 120₂ are oriented in the same second direction as the second fingers of second capacitor plate 122₁ of additional capacitor 120₁ below. However, they are offset vertically (i.e., the second fingers of second capacitor plate 122₂ do not overlay the second fingers of second capacitor plate 122₁). As a result, at least some of the first fingers of first capacitor plate 121₂ of additional capacitor 120₂ partially overlay second fingers of second capacitor plate 122₁ of additional capacitor 120₁ below and at least some of the second fingers of second capacitor plate 122₂ of additional capacitor 120₂ partially overlay first fingers of first capacitor plate 121₁ of additional capacitor 120₁ below.

In any case, in high-density stacked capacitor 100, first capacitor 110 and additional capacitor 120₁ (or, if applicable, all of the multiple additional capacitors 120₁-120*ₙ*) can be electrically connected in parallel. Specifically, as mentioned above, high-density stacked capacitor 100 can have a first terminal 191 and a second terminal 192. Source/drain regions 111-112 of first capacitor 110 and first capacitor plate 121₁ of additional capacitor 120₁ (or, if applicable, first capacitor plates 121₁-121*ₙ* of all additional capacitors 120₁-120*ₙ*) can be electrically connected to first terminal 191. Furthermore, front gate 115 and back gate 116 (via well tap 106) of first capacitor 110 and second capacitor plate 122₁ of additional capacitor 120₁ (or, if applicable, second capacitor plates 122₁-122*ₙ* of additional capacitors 120₁-120*ₙ*) can be electrically connected to second terminal 192. The above-mentioned electrical connections are illustrated in FIGs. 1A-1B. However, to avoid clutter in the figures, these connections are not all illustrated FIG. 1C. Those skilled in the art will recognize that these connections can be made through a combination of MOL contacts 118, which extend through MOL dielectric layer 119 to source/drain regions 111-112 (or, if applicable, to raised source/drain regions 111r-112r), to front gate 115, and to well tap 106, and BEOL interconnects, such as metal wires and/or vias, that provide electrical connections, as required, between these middle of the line contacts and the first and second capacitor plates of the additional capacitor(s).

A high-density stacked capacitor 100, which is configured as described above, can be employed to achieve greater capacitance values within a smaller amount of chip area than conventional capacitors. These gains are due, at least in part, to the electrical connection between front and back gates 115-116 of first capacitor 110, to the presence of additional capacitor(s) 120₁-120*ₙ* in metal level(s) above and overlaying front gate 115 of first capacitor 110, and/or to first capacitor 110 and additional capacitor(s) 120₁-120*ₙ* being electrically connected in parallel, as described. As a result, a relatively high capacitance density of greater than 20.0 femtofarads (fF)/microns (µm)² (e.g., between 24.0fF/µm²) is achievable.

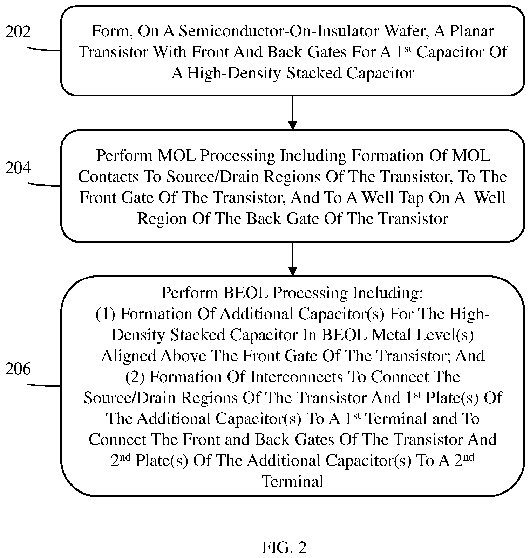

Referring to the flow diagram of FIG. 2, also disclosed herein are embodiments of a method of forming the semiconductor structure 1 of FIGs. 1A-1C, including high-density stacked capacitor 100.

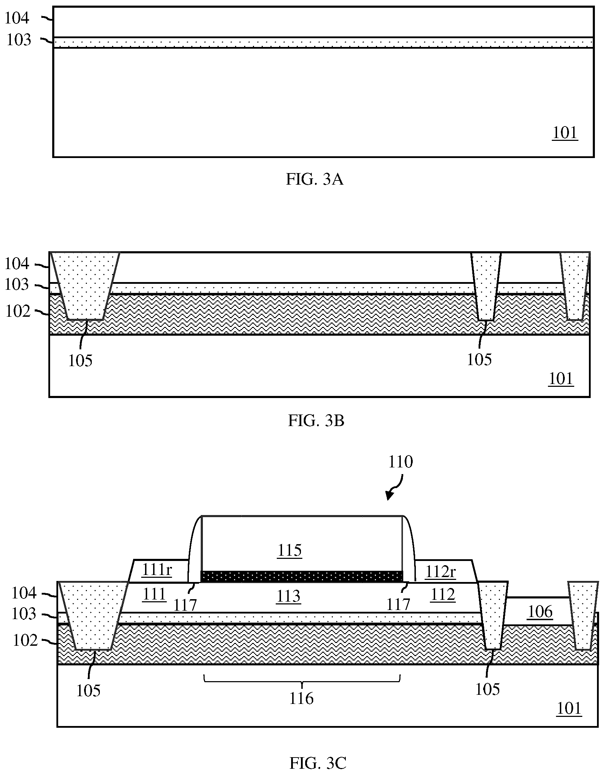

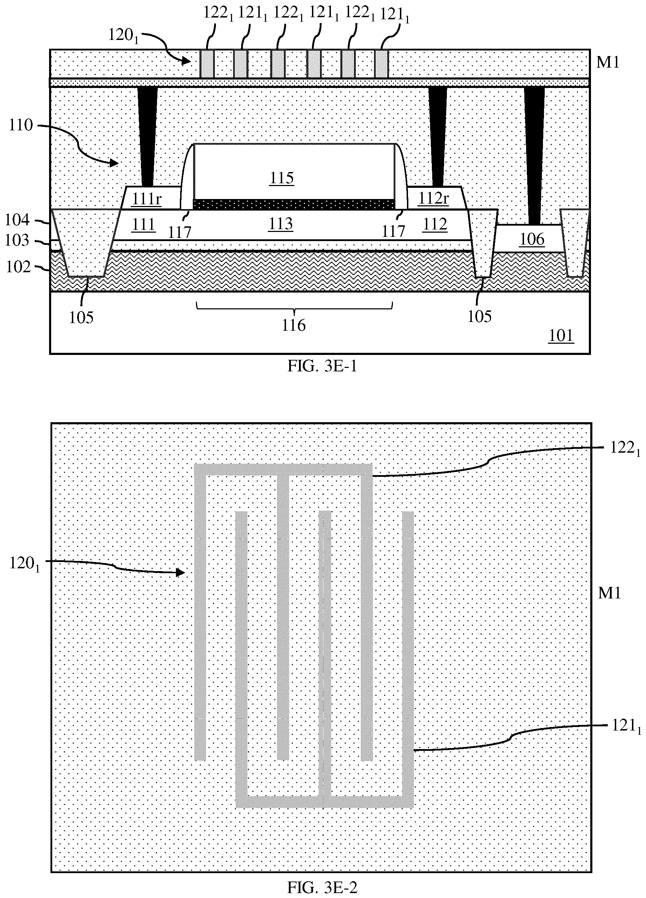

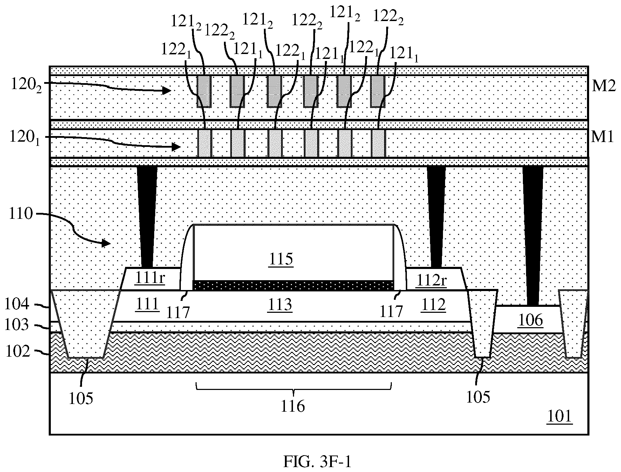

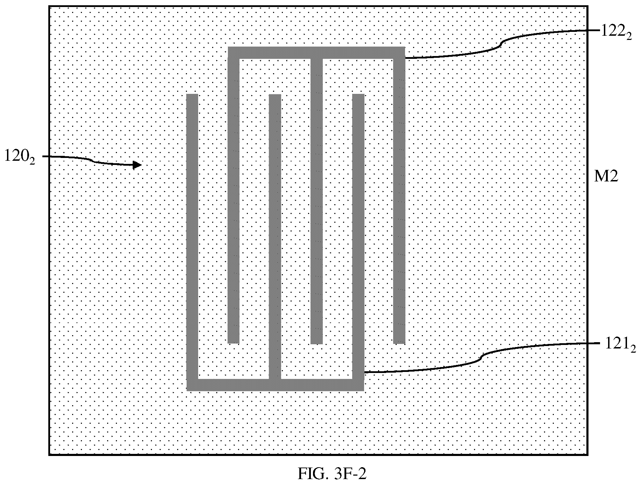

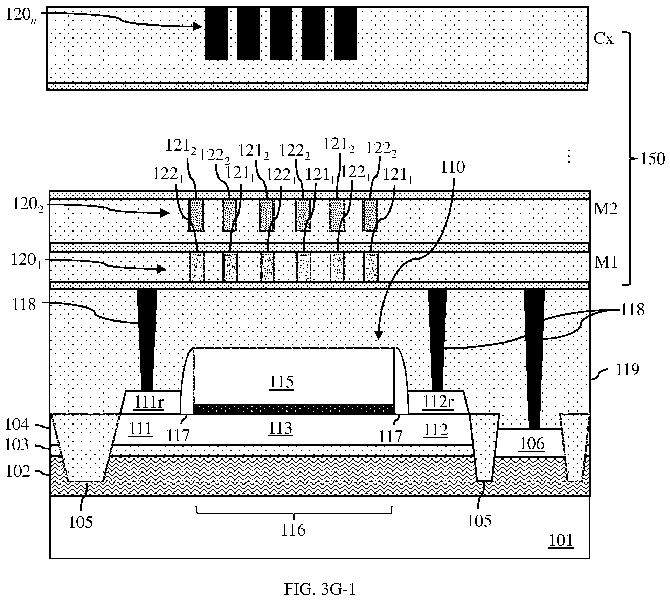

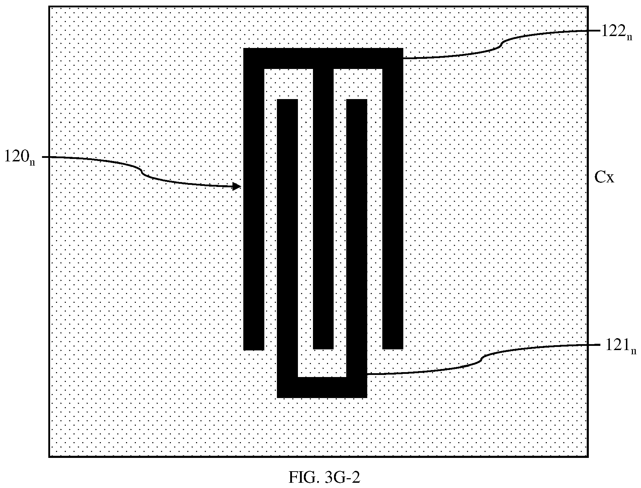

The method can begin with a semiconductor-on-insulator wafer (e.g., silicon-on-insulator (SOI) wafer) (FIG. 3A). The wafer can include a semiconductor substrate 101. Semiconductor substrate 101 can be, for example, a monocrystalline silicon substrate or a substrate of any other suitable monocrystalline semiconductor material (e.g., silicon germanium, etc.). The wafer can further include an insulator layer 103 on semiconductor substrate 101. Insulator layer 103 can be, for example, a silicon dioxide layer or a layer of any other suitable insulator material. The wafer can further include a semiconductor layer 104 on insulator layer 103. Semiconductor layer 104 can be, for example, a monocrystalline silicon layer or a layer of any other suitable monocrystalline semiconductor material (e.g., silicon germanium, etc.).

The method can include forming, on the wafer, a planar transistor and, particularly, a semiconductor-on-insulator field effect transistor (e.g., an SLVT or LVT FDSOI or PDSOI NFET) with both front and back gates for a first capacitor 110 of the high-density stacked capacitor 100 (see process 202 and FIGs. 3B-3C). Techniques for forming such transistors (e.g., FDSOI or PDSOI SLVT or LVT NFETs) are known in the art. An example of one such technique is described below, provided for illustration purposes, and is not intended to be limiting.

Isolation regions 105 (e.g., STI structures) can be formed on the wafer. For example, trenches can be formed (e.g., lithographically patterned and etched) such that they extend vertically through semiconductor layer 104 to and, optionally, through insulator layer 103. The trenches can be formed so as to define boundaries of an active device region for the transistor and further so as to define boundaries for a well tap region adjacent to the transistor. One or more layers of isolation material (e.g., silicon dioxide, silicon oxynitride, silicon nitride, or any other suitable type of isolation material) can be deposited so as to fill the trenches. A polishing process (e.g., a chemical mechanical polishing (CMP) process) can be performed to remove the isolation material from above the top surface of semiconductor layer 104.

Before or after STI formation, a dopant implantation process can be performed to form a well region 102 (e.g., an Nwell) in semiconductor substrate 101 immediately adjacent to insulator layer 103 and aligned below both the active device region and well tap region. Techniques for forming such well regions are known in the art. Thus, the details thereof have been omitted from the specification in order to allow the reader to focus on the salient aspects of the disclosed embodiments related to stacking of the particular types of capacitors, as described, to achieve a high-density stacked capacitor 100.

A gate structure can be formed on the active device region. This gate structure could be a gate-first gate structure (e.g., a gate-first silicon dioxide-polysilicon gate structure, a gate-first high-K dielectric-metal gate structure, or the like). In such a gate-first gate structure, a stack of gate layers can be formed on the active device region. For example, a gate dielectric layer (e.g., one or more layers of gate dielectric material) on the active device region, a gate conductor layer (e.g., one or more layers of gate conductor material) could be formed over the gate dielectric layer, and a dielectric cap layer could be formed over the gate conductor layer. This stack of layers can subsequently be lithographically patterned and etched, thereby forming front gate 115 above a designated channel region within semiconductor layer 104. Alternatively, a sacrificial layer could be formed over the active device region and lithographically patterned and etch, thereby forming a sacrificial gate above the designated channel region. Such a sacrificial gate would subsequently be replaced before back end of the line (BEOL) processing with a replacement metal gate structure, thereby forming front gate 115. In any case, at this point during processing gate sidewall spacers 117 can be formed on sidewalls of the gate structure. In any case, Techniques for forming gates with gate sidewall spacers thereon are known in the art. Thus, the details thereof have been omitted from this specification in order to allow the reader to focus on the salient aspects of the disclosed embodiments related to stacking of the particular types of capacitors, as described, to achieve a high-density stacked capacitor 100.

As mentioned above, total capacitance provided by first capacitor 110 will include at least both front gate capacitance and back gate capacitance. For purposes of this disclosure, front gate capacitance refers to capacitance created by a capacitor formed with the gate conductor material of front gate 115 and channel region 113 as capacitor plates and the gate dielectric material of front gate 115 as the capacitor dielectric. Furthermore, back gate capacitance refers to capacitance created by a capacitor and, particularly, an in-substrate PN junction capacitor formed at the interface between semiconductor substrate material with one type conductivity (e.g., P- semiconductor material) and well region 102 of back gate 116, which is within the semiconductor substrate and which has the opposite type conductivity (e.g., an Nwell).

A mask layer can be formed over the partially completed structure. An opening can be formed (e.g., lithographically patterned and etched) in the mask layer to expose the semiconductor layer 104 in the well tap region (which, as discussed above, is above well region 102 and further adjacent to, but isolated from, the active device region). One or more etch processes can then be performed to remove portions of semiconductor layer 104 and insulator layer 103 from the well tap region, thereby exposing the top surface of semiconductor substrate 101 and, particularly, well region 102 therein. The mask layer can then be removed.

A dopant implantation process could be performed to form source/drain regions 111-112 (e.g., N+ source/drain regions) in portions of semiconductor layer 104 on opposing sides of the gate structure. Additionally, or alternatively, epitaxial semiconductor layers can be deposited onto exposed portions of the top surface of semiconductor layer 104 and in situ doped to form raised source/drain regions 111r-112r (e.g., N+ raised source/drain regions). Such processes can also concurrently form a well tap 106 (e.g., an N+ well tap) within and/or on the top surface of semiconductor substrate 101 immediately adjacent to well region 102 (e.g., an Nwell) in the well tap region. Dopant implantation and epitaxial growth techniques are known in the art. Thus, the details of these techniques have been omitted from this specification in order to allow the reader to focus on the salient aspects of the disclosed embodiments related to stacking of the particular types of capacitors, as described, to achieve a high-density stacked capacitor 100.

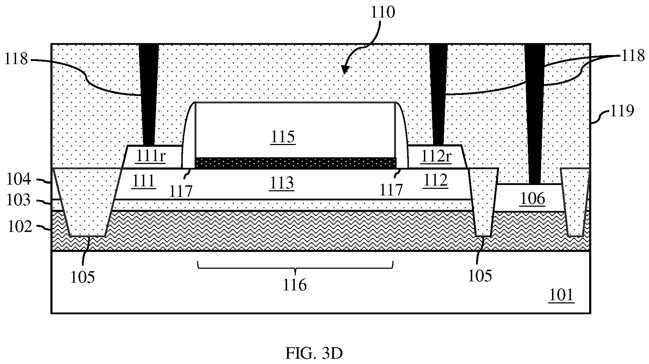

The method can further include performing MOL processing (see process 204 and FIG. 3D). For example, a MOL dielectric layer 119 can be formed over the partially completed structure. MOL dielectric layer 119 can include one or more layers of interlayer dielectric (ILD) material. The ILD material layers can include, for example, an optional conformal etch stop layer (e.g., a conformal silicon nitride layer) and a blanket dielectric layer on the etch stop layer. The blanket dielectric layer can be, for example, a layer of silicon dioxide or a layer of any other suitable ILD material such as borophosphosilicate glass (BPSG) or phosphosilicate glass (PSG)). Additionally, MOL contacts 118 can be formed such that they extend vertically through MOL dielectric layer 119 to the terminals of the transistor. MOL contacts 118 can include, but are not limited to, contacts to source/drain regions 111-112 (or, if applicable, contacts to raised source/drain regions 111r-112r) and a contact to well tap 106 (and thereby to back gate 116). Such MOL contacts can also include a contact to front gate 115, which is not shown in FIG. 3D because it would typically be formed so that it is offset from the active device region. MOL processing techniques are known in the art. Thus, the details thereof have been omitted from this specification in order to allow the reader to focus on the salient aspects of the disclosed embodiments related to stacking of the particular types of capacitors, as described, to achieve a high-density stacked capacitor.

The method can further include performing BEOL processing (see process 206 and FIGs. 3E-1 and 3E-2, FIGs. 3F-1 and 3F-2, and FIGs. 3G-1 and 3G-2). Process 208 can include formation of one or more additional capacitor(s) 120₁-120*ₙ* (e.g., MOMCAP(s), such as AP-MOMCAP(s)). Additional capacitor(s) 120₁-120*ₙ* can be formed at process 208 one after the other as each metal level is formed. Additional capacitor(s) 120₁-120*ₙ* can further be formed at process 208 such that they are aligned over first capacitor 110 and, particularly, over the front gate 115 thereof, such that they are stacked vertically one above the other, and such that they have the desired configurations, as described in detail above with regard to the structure embodiments.

Process 208 can also include formation of various BEOL interconnects (e.g., wires and/or vias) that electrically connect first capacitor 110 (via MOL contacts 118) and additional capacitor(s) 120₁-120*ₙ* in parallel between a first terminal 191 and a second terminal 192, as described in detail above with regard to the structure embodiments. Specifically, process 208 can also be performed so that source/drain regions 111 of first capacitor 110 and all first plate(s) (e.g., 121₁ and, if applicable, 121₂ -121ₙ) of all additional capacitor(s) (e.g., 120₁ and, if applicable, 120₂ -120ₙ) are electrically connected to first terminal 191 and further so that front and back gates 115-116 of first capacitor 110 and all second plate(s) (e.g., 122₁ and, if applicable, 122₂ -122ₙ) of all additional capacitor(s) (e.g., 120₁ and, if applicable, 120₂ -120ₙ) are electrically connected to second terminal 192. BEOL processing techniques that can be employed to achieve such BEOL structures (e.g., MOMCAP(s) and BEOL interconnects) are known in the art. Thus, details thereof have been omitted from this specification in order to allow the reader to focus on salient aspects of the disclosed embodiments related to stacking of the particular types of capacitors, as described, to achieve a high-density stacked capacitor 100.

It should be understood that in the method and structures described above, a semiconductor material refers to a material whose conducting properties can be altered by doping with an impurity. Such semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP).

A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, the present disclosure discloses a high-density stacked capacitor and an associated formation method. The high-density stacked capacitor includes: first and second terminals; and a stack of parallel-connected capacitors between the terminals. The stack includes a first capacitor (e.g., a planar transistor-type capacitor) including: a channel region positioned laterally between source/drain regions, which are connected to the first terminal; and front and back gates, which are above and below the channel region and connected to the second terminal. The stack also includes at least one additional capacitor (e.g., a metal-oxide-metal capacitor (MOMCAP)) aligned above the front gate of the first capacitor in a back end of the line (BEOL) metal level. Optionally, the capacitor includes multiple additional capacitors aligned above the front gate and stacked vertically one above the other in different BEOL metal levels. Each additional capacitor includes interdigitated first and second capacitor plates connected to the first and second terminals, respectively.

The following embodiments are explicitly disclosed.
Embodiment 1:
   A structure comprising:
   a first capacitor including a transistor, wherein the transistor includes: a channel region in a semiconductor layer positioned laterally between source/drain regions; a back gate adjacent to a bottom surface of the semiconductor layer at the channel region; and a front gate adjacent to a top surface of the semiconductor layer at the channel region, and wherein the source/drain regions are connected to a first terminal and wherein the front gate and the back gate are connected to a second terminal;
   a dielectric layer on the transistor; and
   an additional capacitor above the dielectric layer extending at least partially over the front gate, wherein the additional capacitor includes interdigitated capacitor plates connected to the first terminal and the second terminal, respectively. Herein, the additional capacitor may be provided as a single additional capacitor in the structure or, alternatively, the additional capacitor may be provided as one additional capacitor out of a plurality of additional capacitors. Embodiment 2:
   The structure of embodiment 1, further comprising:
   a semiconductor substrate;
   an insulator layer on the semiconductor substrate, wherein the bottom surface of the semiconductor layer is immediately adjacent to the insulator layer; and
   a well region in the semiconductor substrate immediately adjacent to the insulator layer and below the transistor, wherein portions of the insulator layer and the well region adjacent to the channel region opposite the front gate form the back gate.
Embodiment 3:
   The structure of embodiment 2,
   wherein the semiconductor substrate has P-type conductivity and the well region has N-type conductivity, and
   wherein a total capacitance provided by the first capacitor includes at least:
      a front gate capacitance; and
      a back gate capacitance.
Embodiment 4:
   The structure of embodiment 2 or 3, wherein the semiconductor substrate is a P-type silicon substrate, the insulator layer is a silicon dioxide layer, the semiconductor layer is a silicon layer, the transistor is a silicon-on-insulator N-type field effect transistor, and the well region is an N-type well region.
Embodiment 5:
   The structure of one of embodiments 2 to 5, further comprising a well tap within an opening in the insulator layer, wherein the well tap is adjacent the well region and has a same type conductivity at a higher conductivity level than the well region.
Embodiment 6:
   The structure of one of embodiments 1 to 5,
   wherein the interdigitated capacitor plates include a first capacitor plate with first fingers and a second capacitor plate with second fingers,
   wherein at least some of the first fingers extend at least partially across the front gate in one direction, and
   wherein at least some of the second fingers extend at least partially across the front gate in an opposite direction.
Embodiment 7:
   A structure comprising:
   a first capacitor including a transistor, wherein the transistor includes: a channel region in a semiconductor layer positioned laterally between source/drain regions; a back gate adjacent to a bottom surface of the semiconductor layer at the channel region; and a front gate adjacent to a top surface of the semiconductor layer at the channel region, wherein the source/drain regions are connected to a first terminal and wherein the front gate and the back gate are connected to a second terminal; and
   a dielectric layer on the transistor; and
   a stack of additional capacitors above the dielectric layer in different metal levels and extending at least partially over the front gate, wherein each additional capacitor includes interdigitated capacitor plates connected to the first terminal and the second terminal, respectively.
   In some illustrative examples of embodiment 7, embodiments 1 and 7 may be related in that embodiment 1 defines one additional capacitor which may be one additional capacitor of a possible plurality of additional capacitors, wherein the additional capacitors provide a stack of additional capacitors as defined in embodiment 7 above. Accordingly, embodiment 7 may be also combined with any of embodiments 2 to 6.
Embodiment 8:
   The structure of embodiment 7, further comprising:
   a semiconductor substrate;
   an insulator layer on the semiconductor substrate, wherein the bottom surface of the semiconductor layer is immediately adjacent to the insulator layer; and
   a well region in the semiconductor substrate immediately adjacent to the insulator layer and below the transistor, wherein portions of the insulator layer and the well region adjacent to the channel region opposite the front gate form the back gate.
Embodiment 9:
   The structure of embodiment 7 or 8,
   wherein the semiconductor substrate has P-type conductivity and the well region has N-type conductivity, and
   wherein a total capacitance provided by the first capacitor includes at least:
      a front gate capacitance; and
      a back gate capacitance.
Embodiment 10:
   The structure of one of embodiments 7 to 9, wherein the semiconductor substrate is a P-type silicon substrate, the insulator layer is a silicon dioxide layer, the semiconductor layer is a silicon layer, the transistor is a silicon-on-insulator N-type field effect transistor, and the well region is an N-type well region.
Embodiment 11:
   The structure of one of embodiments 7 to 10, further comprising a well tap within an opening in the insulator layer, wherein the well tap is adjacent the well region and has a same type conductivity at a higher conductivity level than the well region.
Embodiment 12:
   The structure of one of embodiments 7 to 11,
   wherein, within each additional capacitor in the stack, the interdigitated capacitor plates include a first capacitor plate first fingers and a second capacitor plate with second fingers,
   wherein at least some of the first fingers extend at least partially across the front gate in one direction, and
   wherein at least some of the second fingers extend at least partially across the front gate in an opposite direction.
Embodiment 13:
   The structure of embodiment 11 or 12, wherein, within the stack, first fingers of first capacitor plates of at least some of the additional capacitors are offset vertically and second fingers of second capacitor plates of at least some of the additional capacitors are offset vertically.
Embodiment 14:
   The structure of one of embodiments 11 to 13, wherein at least some additional capacitors in the stack have different physical parameters.
Embodiment 15:
   The structure of embodiment 14, wherein the different physical parameters include any of different finger lengths, different finger spacings, different finger widths, and different finger thicknesses.
Embodiment 16:
   A method including:
   forming a first capacitor including a transistor, wherein the transistor includes: a channel region in a semiconductor layer positioned laterally between source/drain regions; a back gate adjacent to a bottom surface of the semiconductor layer at the channel region; and a front gate adjacent to a top surface of the semiconductor layer at the channel region, and wherein the source/drain regions are connected to a first terminal and wherein the front gate and the back gate are connected to a second terminal;
   forming a dielectric layer on the transistor; and
   forming at least one additional capacitor above the dielectric layer extending at least partially over the front gate, wherein the additional capacitor includes interdigitated capacitor plates connected to the first terminal and the second terminal, respectively.
Embodiment 17:
   The method of embodiment 16, further comprising
   providing a semiconductor-on-insulator structure including: semiconductor substrate; an insulator layer on the semiconductor substrate; and the semiconductor layer on the insulator layer; and
   forming a well region in the semiconductor substrate immediately adjacent to the insulator layer, wherein portions of the insulator layer and the well region form the back gate.
Embodiment 18:
   The method of embodiment 16 or 17, wherein the semiconductor substrate is a P-type silicon substrate, the insulator layer is a silicon dioxide layer, the semiconductor layer is a silicon layer, the transistor is a silicon-on-insulator N-type field effect transistor, and the well region is an N-type well region.
Embodiment 19:
   The method of one of embodiments 16 to 18, wherein the forming of the at least one additional capacitor includes concurrently forming, for the interdigitated capacitor plates of each additional capacitor:
   a first capacitor plate with first fingers extending at least partially across the front gate in one direction; and
   a second capacitor plate with second fingers extending at least partially across the front gate in an opposite direction.
Embodiment 20:
   The method of embodiment 19, wherein the forming of the at least one additional capacitor includes forming a stack of additional capacitors and wherein, within the stack, first fingers of first capacitor plates of at least some of the additional capacitors are offset vertically and second fingers of second capacitor plates of at least some of the additional capacitors are offset vertically.
Embodiment 21:
   The method of one of embodiments 16 to 20, wherein the structures of one of embodiments 1 to 15 is formed.

In the above description, the term vertically may be understood as indicating a direction within a virtual plane which is oriented perpendicular to the bottom surface of the semiconductor layer at the channel region. Lateral may be understood as indicating a direction within a virtual plane which is oriented in parallel with the bottom surface of the semiconductor layer at the channel region. Vertical and lateral may be dimensions perpendicular to each other. Furthermore, "include" may be understood as synonymous with "comprise."

## Claims

1. A structure comprising:
a first capacitor including a transistor, wherein the transistor includes: a channel region in a semiconductor layer positioned laterally between source/drain regions; a back gate adjacent to a bottom surface of the semiconductor layer at the channel region; and a front gate adjacent to a top surface of the semiconductor layer at the channel region, and wherein the source/drain regions are connected to a first terminal and wherein the front gate and the back gate are connected to a second terminal;
a dielectric layer on the transistor; and
at least one additional capacitor above the dielectric layer extending at least partially over the front gate, wherein the at least one additional capacitor includes interdigitated capacitor plates connected to the first terminal and the second terminal, respectively.

2. The structure of claim 1, further comprising:
a semiconductor substrate;
an insulator layer on the semiconductor substrate, wherein the bottom surface of the semiconductor layer is immediately adjacent to the insulator layer; and
a well region in the semiconductor substrate immediately adjacent to the insulator layer and below the transistor, wherein portions of the insulator layer and the well region adjacent to the channel region opposite the front gate form the back gate.

3. The structure of claim 2,
wherein the semiconductor substrate has P-type conductivity and the well region has N-type conductivity, and
wherein a total capacitance provided by the first capacitor includes at least:
a front gate capacitance; and
a back gate capacitance.

4. The structure of claim 2 or 3, wherein the semiconductor substrate is a P-type silicon substrate, the insulator layer is a silicon dioxide layer, the semiconductor layer is a silicon layer, the transistor is a silicon-on-insulator N-type field effect transistor, and the well region is an N-type well region.

5. The structure of one of claims 2 to 4, further comprising a well tap within an opening in the insulator layer, wherein the well tap is adjacent the well region and has a same type conductivity at a higher conductivity level than the well region.

6. The structure of one of claims 1 to 5,
wherein the interdigitated capacitor plates include a first capacitor plate with first fingers and a second capacitor plate with second fingers,
wherein at least some of the first fingers extend at least partially across the front gate in one direction, and
wherein at least some of the second fingers extend at least partially across the front gate in an opposite direction.

7. The structure of one of claims 1 to 6, further comprising:
a plurality of additional capacitors forming a stack of additional capacitors above the dielectric layer in different metal levels and extending at least partially over the front gate, wherein each additional capacitor includes interdigitated capacitor plates connected to the first terminal and the second terminal, respectively.

8. The structure of claim 7,
wherein, within each additional capacitor in the stack, the interdigitated capacitor plates include a first capacitor plate first fingers and a second capacitor plate with second fingers,
wherein at least some of the first fingers extend at least partially across the front gate in one direction, and
wherein at least some of the second fingers extend at least partially across the front gate in an opposite direction.

9. The structure of claim 7 or 8, wherein, within the stack, first fingers of first capacitor plates of at least some of the additional capacitors are offset vertically and second fingers of second capacitor plates of at least some of the additional capacitors are offset vertically.

10. The structure of one of claims 7 to 9, wherein at least some additional capacitors in the stack have different physical parameters, wherein the different physical parameters preferably include different finger lengths and/or different finger spacings and/or different finger widths and/or different finger thicknesses.

11. A method including:
forming a first capacitor including a transistor, wherein the transistor includes: a channel region in a semiconductor layer positioned laterally between source/drain regions; a back gate adjacent to a bottom surface of the semiconductor layer at the channel region; and a front gate adjacent to a top surface of the semiconductor layer at the channel region, and wherein the source/drain regions are connected to a first terminal and wherein the front gate and the back gate are connected to a second terminal;
forming a dielectric layer on the transistor; and
forming at least one additional capacitor above the dielectric layer extending at least partially over the front gate, wherein the additional capacitor includes interdigitated capacitor plates connected to the first terminal and the second terminal, respectively.

12. The method of claim 11, further comprising
providing a semiconductor-on-insulator structure including: semiconductor substrate; an insulator layer on the semiconductor substrate; and the semiconductor layer on the insulator layer; and
forming a well region in the semiconductor substrate immediately adjacent to the insulator layer, wherein portions of the insulator layer and the well region form the back gate.

13. The method of claim 12, wherein the semiconductor substrate is a P-type silicon substrate, the insulator layer is a silicon dioxide layer, the semiconductor layer is a silicon layer, the transistor is a silicon-on-insulator N-type field effect transistor, and the well region is an N-type well region.

14. The method of one of claims 11 to 13, wherein the forming of the at least one additional capacitor includes concurrently forming, for the interdigitated capacitor plates of each additional capacitor:
a first capacitor plate with first fingers extending at least partially across the front gate in one direction; and
a second capacitor plate with second fingers extending at least partially across the front gate in an opposite direction.

15. The method of claim 14, wherein the forming of the at least one additional capacitor includes forming a stack of additional capacitors and wherein, within the stack, first fingers of first capacitor plates of at least some of the additional capacitors are offset vertically and second fingers of second capacitor plates of at least some of the additional capacitors are offset vertically.
